# EUROPEAN PATENT SPECIFICATION

(11) **EP 3 747 933 B1**
(45) Date of publication and mention of the grant of the patent: **07.06.2023**
(21) Application number: 19746694.9
(22) Date of filing: 29.01.2019
(51) Int. Cl.: C08G 75/045, C08K 3/26, C08L 81/02, C09J 181/02, C09J 4/00, C09J 4/06, C08F 2/42

(54) **RESIN COMPOSITION AND CURED MATERIAL OF SAME, ADHESIVE, SEMICONDUCTOR DEVICE, AND ELECTRONIC COMPONENT**
HARZZUSAMMENSETZUNG UND GEHÄRTETES MATERIAL DAVON, KLEBSTOFF, HALBLEITERBAUELEMENT UND ELEKTRONISCHE KOMPONENTE
COMPOSITION DE RÉSINE ET MATÉRIAU DURCI DE CELLE-CI, ADHÉSIF, DISPOSITIF SEMI-CONDUCTEUR ET COMPOSANT ÉLECTRONIQUE

(30) Priority: 30.01.2018 JP 2018013291
(43) Date of publication of application: 09.12.2020
(73) Proprietor: Namics Corporation, Niigata-shi, Niigata 950-3131 (JP)
(72) Inventor: ABE, Nobuyuki, Niigata-shi, Niigata 950-3131 (JP); IWAYA, Kazuki, Niigata-shi, Niigata 950-3131 (JP)
(74) Representative: Zimmermann, Tankred Klaus
(86) International application number: PCT/JP2019/002991
(87) International publication number: WO 2019/151256

(56) References cited:
- WO-A1-2016/143777
- CN-A- 107 011 514
- CN-A- 107 641 200
- JP-A- H1 121 352
- JP-A- 2015 517 012
- JP-A- 2016 512 278
- US-A- 5 411 776
- US-A1- 2015 065 600

## Description

### TECHNICAL FIELD

The present disclosure relates to a resin composition that is curable by light and heat, a cured product thereof, an adhesive agent, a semiconductor device, and an electronic component. More particularly, this resin composition can be, for example, temporarily fixed by light irradiation, and permanently cured by heating.

### BACKGROUND ART

An adhesive agent of a type to be temporarily fixed by ultraviolet (UV) irradiation and permanently cured by heat is used in many fields (for example, see PATENT LITERATURES 1 and 2). Such an adhesive agent is often utilized especially in image sensor modules. In the production process of image sensor modules, lenses or the like used in image sensor modules deteriorate when the temperature becomes high. Therefore, an adhesive agent and sealing material used in the production of image sensor modules are required to be curable at low temperature. However, it is extraordinarily difficult to impart UV curing properties to a thiol-based adhesive agent. This is because a curing reaction between acrylate resin having UV curing properties and thiol resin is more likely to proceed than a curing reaction between resin other than acrylate resin (for example, epoxy resin) and thiol resin. Therefore, the pot life is shortened to the level where practical use is disabled.

WO 2016/143777 A1, US 2015/065600 A1, US 5 411 776 A and CN 107 011 514 A disclose adhesive agents or sealants.

In view of the above-described problem, a resin composition including (A) an acrylic resin, (B) a thiol compound, (C) a latent curing agent, (D) a radical polymerization inhibitor, and (E) an anionic polymerization retarder has been proposed (PATENT LITERATURE 3), for a purpose of providing a resin composition having sufficiently long pot life, light curing properties, and heat curing properties.

### CITATION LIST

### PATENT LITERATURE

PATENT LITERATURE 1: JP-A-2009-51954
PATENT LITERATURE 2: WO 2005/052021 A
PATENT LITERATURE 3: JP-A-2014-77024

### SUMMARY OF THE INVENTION

### PROBLEMS TO BE SOLVED BY THE INVENTION

However, it has been found that the above-described resin composition including (A) an acrylic resin, (B) a thiol compound, (C) a latent curing agent, (D) a radical polymerization inhibitor, and (E) an anionic polymerization retarder sometimes does not have sufficient moisture resistance reliability due to the hydrolysis of acrylic resin as a base resin.

An object of the present disclosure is to provide: a resin composition that has high moisture resistance reliability after curing (particularly, high shear strength after a moisture resistance test), is curable at low temperature, and has light curing properties and heat curing properties; an adhesive agent containing this resin composition; a cured product of the resin composition; a semiconductor device containing this cured product; and an electronic component containing the semiconductor device.

### SOLUTIONS TO THE PROBLEMS

The present inventors intensively conducted research for solving the aforementioned problems. As a result, the present inventors could obtain a resin composition that has high moisture resistance reliability after curing (particularly, high shear strength after a moisture resistance test), and has light curing properties and heat curing properties, by adding a multifunctional acrylate resin, a multifunctional group thiol resin, and a specific calcium carbonate filler.

### EFFECTS OF THE INVENTION

There is provided a resin composition that has high moisture resistance reliability after curing (particularly, high shear strength after a moisture resistance test), is curable at low temperature, and has light curing properties and heat curing properties.

There can be obtained an adhesive agent that has high moisture resistance reliability (particularly, high shear strength after a moisture resistance test) of the resin composition after curing, is curable at low temperature, and has light curing properties and heat curing properties.

There can also be obtained a cured product of the resin composition that has high moisture resistance reliability after curing (particularly, high shear strength after a moisture resistance test), and has light curing properties and heat curing properties.

There can also be obtained a highly reliable semiconductor device, for example, an image sensor module, by the cured product of the resin composition that has high moisture resistance reliability after curing (particularly, high shear strength after a moisture resistance test), and has light curing properties and heat curing properties.

There can also be obtained a highly reliable electronic component including the semiconductor device containing the cured product of the resin composition that has high moisture resistance reliability after curing (particularly, high shear strength after a moisture resistance test), and has light curing properties and heat curing properties.

### DESCRIPTION OF THE EMBODIMENTS

The resin composition according to the present embodiment (hereinafter, referred to as the resin composition) includes
(A) a multifunctional (meth)acrylate resin,
(B) a multifunctional thiol resin, and
(C) a calcium carbonate filler having a purity of 99% or more.

The multifunctional (meth)acrylate resin as the component (A) can impart transparency and appropriate hardness to the resin composition after curing. The multifunctional acrylate resin as the component (A) is not particularly limited, as long as it has two or more functional groups. Examples of the multifunctional (meth)acrylate resin may include diacrylate and/or dimethacrylate of tris(2-hydroxyethyl)isocyanurate; tris(2-hydroxyethyl)isocyanurate triacrylate and/or trimethacrylate; trimethylolpropane triacrylate and/or trimethacrylate, or oligomers thereof; pentaerythritol triacrylate and/or trimethacrylate, or oligomers thereof; polyacrylate and/or polymethacrylate of dipentaerythritol; tris(acryloxyethyl)isocyanurate; caprolactone-modified tris(acryloxyethyl)isocyanurate; caprolactone-modified tris(methacryloxyethyl)isocyanurate; polyacrylate and/or polymethacrylate of alkyl-modified dipentaerythritol; polyacrylate and/or polymethacrylate of caprolactone-modified dipentaerythritol; ethoxylated bisphenol A diacrylate and/or ethoxylated bisphenol A dimethacrylate; and polyester acrylate and/or polyester methacrylate. From the viewpoint of reactivity, the component (A) is preferably a multifunctional acrylate resin that substantially does not contain multifunctional methacrylate.

From the viewpoint of the preparation of the resin composition and dispensing properties, the component (A) preferably has a viscosity of 0.02 to 20 Pa·s.

Examples of a commercially available product of the component (A) may include polyester acrylate (product name: M7100) manufactured by Toagosei Co., Ltd., dimethylol-tricyclodecane diacrylate (product name: Light Acrylate DCP-A) manufactured by Kyoeisha Chemical Co., Ltd., and polyester acrylate (product name: EBECRYL 810) manufactured by Daicel-Allnex Ltd. As the component (A), a single component may be used, or two or more components may be used in combination.

The multifunctional thiol resin as the component (B) imparts elasticity and moisture resistance to the resin composition. The component (B) is not particularly limited, as long as it has two or more functional groups. However, from the viewpoint of moisture resistance, the component (B) preferably has a structure having no ester bond in the molecule. An example of the component (B) may include a glycoluril compound represented by general formula (1) below.

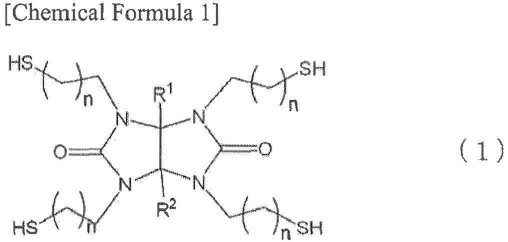

In general formula (1), R¹ and R² are each independently hydrogen, an alkyl group of 1 to 10 carbon atoms, or a phenyl group. n is an integer of 0 to 10. Also, the component (B) may be a compound represented by chemical formula (2) or chemical formula (3) below.

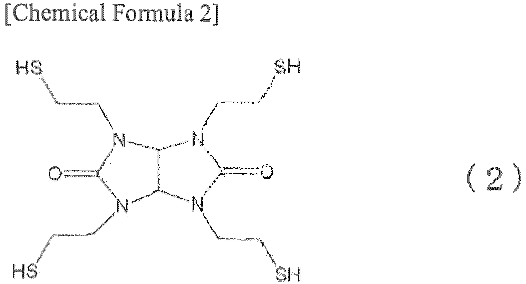

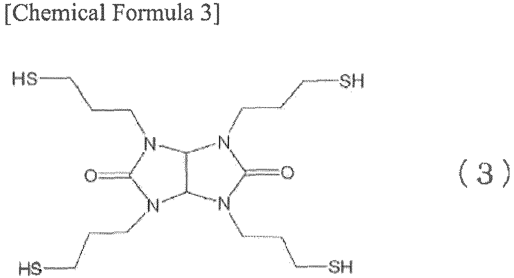

The compound represented by chemical formula (2) or chemical formula (3) is a further preferable compound as the component (B).

Furthermore, an example of the multifunctional thiol resin having no ester bond in the molecule may include a multifunctional thiol resin represented by general formula (4),

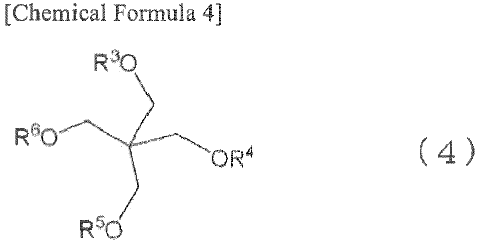

In general formula (4), R³, R⁴, R⁵, and R⁶ are each independently hydrogen or CₙH₂ₙSH (n is 2 to 6). Furthermore, at least one of R³, R⁴, R⁵, and R⁶ is CₙH₂ₙSH (n is 2 to 6). In the thiol compound as the component (B) represented by general formula (4), n is preferably 2 to 4, from the viewpoint of curing properties. Also, this thiol compound is more preferably a mercaptopropyl group in which n is 3, from the viewpoint of a balance between the physical properties of the cured product and the curing speed. The component (B) represented by general formula (4) itself has a sufficiently flexible backbone. Therefore, this component (B) is effective when the elastic modulus of the cured product is desirably low. The elastic modulus of the cured product can be controlled by adding the component (B) represented by general formula (4). Therefore, the adhesive strength (particularly, peel strength) after curing can be increased.

Examples of a commercially available product of the component (B) may include thiol glycoluril derivatives (product name: TS-G (corresponding to chemical formula (2), thiol equivalent weight: 100 g/eq) and C3 TS-G (corresponding to chemical formula (3), thiol equivalent weight: 114 g/eq)) manufactured by Shikoku Chemicals Corporation, and a thiol compound (product name: PEPT (corresponding to general formula (4), thiol equivalent weight: 124 g/eq)) manufactured by SC Organic Chemical Co., Ltd. As the component (B), a single component may be used, or two or more components may be used in combination.

Also, the component (B) preferably contains 50 to 100 parts by mass of a glycoluril compound relative to 100 parts by mass of the component (B), from the viewpoint of maintaining the shear strength after curing of the resin composition. The content of the glycoluril compound in the component (B) is more preferably 60 to 100 parts by mass, further preferably 70 to 100 parts by mass.

As the component (B), a multifunctional thiol resin having an ester bond in the molecule may also be used. In this case, the content of this multifunctional thiol resin, relative to 100 parts by mass of the component (B), is preferably less than 50 parts by mass, more preferably less than 40 parts by mass, further preferably less than 30 parts by mass. According to the present embodiment, the moisture resistance of the cured product is unlikely to deteriorate owing to the component (C), even if the multifunctional thiol resin having an ester bond in the molecule is used as the component (B). However, the increase of the component (C) leads to the viscosity increase of the resin composition. As a result, workability is likely to deteriorate. Therefore, the content of the multifunctional thiol resin is preferably the above-described amount.

Examples of the multifunctional thiol resin having an ester bond in the molecule may include pentaerythritol tetrakis(3-mercaptopropionate), trimethylolpropane tris(3-mercaptopropionate), dipentacrythritol hexakis(3-mercaptopropionate), pentaerythritol tetrakis(3-mercaptobutyrate), tris-[(3-mercaptopropionyloxy)-ethyl]-isocyanurate, pentaerythritol tetrakis(3-mercaptobutyrate), 1,4-bis(3-mercaptobutyryloxy)butane, 1,3,5-tris(3-mercaptobutyryloxyethyl)-1,3,5-triazine-2,4,6(1H,3H,5H)-trione, trimethylolpropane tris(3-mercaptobutyrate), and trimethylolethane tris(3-mercaptobutyrate).

The calcium carbonate filler having a purity of 99% or more as the component (C) improves the moisture resistance reliability of the resin composition after curing. This mechanism will be described. First, an ester bond contained in the cured product of the resin composition according to the present embodiment hydrolyzes under high temperature and high humidity conditions to generate carboxylic acid. Next, this carboxylic acid causes the system to become acidic. Accordingly, calcium carbonate is dissolved and ionized to generate a divalent calcium ion. This calcium ion exchanges an ion with the carboxylic acid generated through the hydrolysis of the cured product to form an ionic bond with a carbonate. Accordingly, two carbonates are crosslinked.

Here, the impurities of the calcium carbonate filler are measured by an ICP emission spectrochemical analyzer. It is noted that in the measurement of magnesium, iron, and strontium, a 50-fold aqueous dilute solution of measured 2 g of calcium carbonate is prepared using a volumetric flask. In the measurement of sodium and potassium, a 10-fold aqueous dilute solution of measured 5 g of calcium carbonate is prepared using a volumetric flask. The calibration curve to be used may be appropriately selected depending on an intended element.

Here, a low-purity (heavy) calcium carbonate filler contains a large number of monovalent ions such as potassium and sodium. These monovalent ions are easily dissolved in water. The monovalent ions exchange ions with carboxylic acid to form ionic bonds with carbonates. Accordingly, carbonates are capped by the monovalent ions. This possibly causes carbonates to become unlikely to be crosslinked. Therefore, a high-purity calcium carbonate filler is preferably used.

Calcium carbonate constituting the filler is roughly classified into two: light calcium carbonate and heavy calcium carbonate. Light calcium carbonate is chemically synthesized by a carbon dioxide reaction method or a soluble salt reaction method. Therefore, light calcium carbonate has the characteristics that the purity is high, and the crystal form is calcite or aragonite. The shape of light calcium carbonate is cubic or fusiform. Examples of light calcium carbonate may typically include colloidal calcium carbonate, semi-colloidal calcium carbonate, and slight calcium carbonate (also called light calcium carbonate).

Colloidal calcium carbonate has, for example, a cubic shape. The average particle size thereof is equal to or more than 0.01 µm and less than 0.1 µm. The crystal form thereof is calcite. Semi-colloidal calcium carbonate has, for example, a cubic shape. The average particle size thereof is equal to or more than 0.1 µm and less than 1.0 µm. The crystal form thereof is calcite. Slight calcium carbonate has, for example, a fusiform shape. The average particle size thereof is equal to or more than 1.0 µm. The crystal form thereof is calcite or aragonite.

Heavy calcium carbonate is produced by grinding and classifying limestone having a calcite crystal form. Therefore, heavy calcium carbonate is less expensive. However, heavy calcium carbonate has the characteristics that the shape is indefinite, and the purity is low.

The shape of the component (C) is preferably cubic or fusiform, and more preferably cubic from the viewpoint of the liquid properties of the resin composition.

The average particle size of the primary particles of the component (C) is preferably 0.01 to 15 µm, more preferably 0.01 to 1 µm, further preferably 0.01 to 0.9 µm, particularly preferably 0.01 to 0.8 µm. When the average particle size of the primary particles is less than 0.01 µm, the component (C) is likely to be aggregated. On the other hand, when the average particle size of the primary particles is more than 15 µm, the effect of improving moisture resistance reliability is likely to decrease.

In the resin composition, [thiol equivalent weight of component (B)]/[acrylate equivalent weight of component (A)] is preferably 0.5 to 2.0, more preferably 0.5 to 1.5. The thiol equivalent weight of the component (B) is theoretically a number obtained by dividing the molecular weight of the component (B) by the number of thiol groups in one molecule. An actual thiol equivalent weight can be determined by, for example, calculating a thiol number by measuring a potential difference. The equivalent weight of acrylate resin is theoretically equal to a number obtained by dividing the molecular weight of acrylate resin by the number of acryl groups (or methacryl groups) in one molecule. An actual acrylate equivalent weight can be measured by, for example, NMR. When [thiol equivalent weight of component (B)]/[acrylate equivalent weight of component (A)] is in the range of 0.5 to 2.0, certain amounts of the acryl group and the thiol group react. Therefore, high adhesive strength can be easily expressed. When the equivalent weight is less than 0.5 or more than 2.0, a molecular crosslink is not sufficiently formed. Therefore, there is a probability that bleeding may occur on the surface of the cured product. Also, there is a probability that peel strength may decrease.

The content of the component (A), relative to 100 parts by mass of the resin composition, is preferably 10 to 60 parts by mass, from the viewpoint of the adhesive strength of the resin composition.

The content of the component (C), relative to 100 parts by mass of the resin composition, is preferably 7 to 35 parts by mass. When the content of the component (C) is less than 7 parts by mass, moisture resistance reliability is likely to deteriorate. On the other hand, when the content of the component (C) is more than 35 parts by mass, viscosity increases. Accordingly, workability is likely to deteriorate.

The resin composition preferably further includes (D) a radical polymerization inhibitor. The radical polymerization inhibitor as the component (D) is added to enhance the stability during the storage of the resin composition. That is, the radical polymerization inhibitor as the component (D) is added to suppress the progress of an unintended radical polymerization reaction. The (meth)acrylate resin as the component (A) itself sometimes generates radicals with a low probability. The generated radicals sometimes serve as a base point from which an unintended radical polymerization reaction progresses. When the radical polymerization inhibitor is added, the progress of such an unintended radical polymerization reaction of the component (A) can be suppressed.

As the component (D), any known component can be used. For example, the component (D) to be used is preferably at least one selected from the group consisting of N-nitroso-N-phenylhydroxylamine aluminum, triphenylphosphine, p-methoxyphenol, and hydroquinone. Also, as the component (D), known radical polymerization inhibitors disclosed in JP-A-2010-1 17545, JP-A-2008-184514 can be used. As the component (D), a single component may be used, or two or more components may be used in combination.

The resin composition preferably further includes (E) an anionic polymerization retarder. The anionic polymerization retarder as the component (E) imparts the stability during storage to the resin composition. When a latent curing accelerator (described later) is used, the anionic polymerization retarder as the component (E) is added to suppress an unintended reaction between an amino group possibly contained in the latent curing accelerator and the component (B). Imidazole and tertiary amine possibly contained in the latent curing accelerator has an amino group. When the amino group reacts with the component (B), polymerization is initiated. The latent curing accelerator is designed such that the reaction of an amino group is unlikely to occur at room temperature. However, there remains a slight possibility that an amino group comes to react with the component (B) at room temperature. The component (E) reacts with an amino group before the amino group reacts with the component (B). Accordingly, the component (E) has the function of suppressing the unintended reaction between an amino group and the component (B).

As the component (E), any known component can be used. For example, the component (E) to be used is preferably at least one selected from the group consisting of boric acid ester, aluminum chelate, and organic acid. Examples of the boric acid ester to be used may include boric acid ester disclosed in JP-A-2011-026539 and Re-publication of WO 2005/070991 A. An example of the aluminum chelate to be used may include aluminum chelate disclosed in Re-publication of WO 2005/070991 A. An example of the organic acid to be used may include organic acid disclosed in JP-T-2002-509178. Examples of a commercially available product of the component (E) may include triisopropyl borate and barbituric acid. As the component (E), a single component may be used, or two or more components may be used in combination.

The content of the component (D), relative to 100 parts by mass of the resin composition, is preferably 0.0001 to 1.0 part by mass. Accordingly, the stability during the storage of the resin composition can be further enhanced. Therefore, the pot life of the resin composition can be further extended.

The content of the component (E), relative to 100 parts by mass of the resin composition, is preferably 0.1 to 20 parts by mass. Accordingly, the stability during the storage of the resin composition can be further enhanced. Therefore, the pot life of the resin composition can be further extended.

The resin composition according to the present embodiment preferably further includes (F) a glycidyl group-containing compound other than the multifunctional acrylate resin having a glycidyl group. The reactivity of the component (F) with the component (B) due to heating is lower than the component (A). Therefore, the component (F) contributes to the enhancement of the stability during the storage of the resin composition, similarly to the anionic polymerization retarder as the component (E).

From the viewpoint of the reactivity with the component (B), the component (F) is preferably epoxy resin, a vinyl compound having at least one glycidyl group, or polybutadiene having at least one glycidyl group. Examples of a commercially available product of the epoxy resin may include epoxy resin (product name: EXA835LV) manufactured by DIC Corporation, and epoxy resin (product name: YDF8170) manufactured by Nippon Steel and Sumitomo Metal Corporation. An example of a commercially available product of the polybutadiene having at least one glycidyl group may include epoxidized 1,2-polybutadiene manufactured by ADEKA Corporation. As the component (F), a single component may be used, or two or more components may be used in combination.

The content of the component (F), relative to 100 parts by mass of the resin composition, is preferably 1 to 50 parts by mass, from the viewpoint of the pot life and UV curing properties of the resin composition. It is noted that when epoxy resin is used, (thiol equivalent weight)/[(acrylate equivalent weight) + (epoxy equivalent weight)] is preferably 0.5 to 2.0.

The resin composition preferably further includes a radical polymerization initiator. When the resin composition includes the radical polymerization initiator, the resin composition can be cured by heating or UV irradiation in a short time. The radical polymerization initiator is not particularly limited. Any known material can be used. Specific examples of the radical polymerization initiator may include: dialkyl peroxide such as dicumyl peroxide, t-butylcumyl peroxide, 1,3-bis(2-t-butylperoxyisopropyl)benzene, and 2,5-dimethyl-2,5-bis(t-butylperoxy)hexane; peroxy ketal such as 1,1-bis(t-butylperoxy)cyclohexane, 1,1-bis(t-butylperoxy)-3,3,5-trimethylcyclohexane, 1,1-bis(t-amylperoxy)cyclohexane, 2,2-bis(t-butylperoxy)butane, n-butyl 4,4-bis(t-butylperoxy)valerate, and ethyl 3,3-(t-butylperoxy)butyrate; and alkyl peroxyester such as t-butylperoxy 2-ethylhexanoate, 1,1,3,3-tetramethylbutylperoxy 2-ethylhexanoate, t-butylperoxyisobutyrate, t-butylperoxymaleate, and t-butylperoxybenzoate. Other specific examples of the radical polymerization initiator may include 1-hydroxycyclohexyl phenyl ketone, 2-hydroxy-2-methyl-1-phenylpropane-1-one, diethoxyacetophenone, 1-(4-isopropylphenyl)-2-hydroxy-2-methylpropane-1-one, 1-(4-dodecylphenyl)-2-hydroxy-2-methylpropane-1-one, 4-(2-hydroxyethoxy)-phenyl(2-hydroxy-2-propyl)ketone, 2-methyl-1-[4-(methylthio)phenyl]-2-morpholinopropane-1, benzoin, benzoin methyl ether, benzoin ethyl ether, benzoin isopropyl ether, benzoin n-butyl ether, benzoin phenyl ether, benzyl dimethyl ketal, benzophenone, benzoylbenzoic acid, methyl benzoylbenzoate, 4-phenylbenzophenone, hydroxybenzophenone, acrylated benzophenone, 4-benzoyl-4'-methyldiphenyl sulfide, 3,3'-dimethyl-4-methoxybenzophenone, thioxanthone, 2-chlorthioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone, 2,4,6-trimethylbenzoyldiphenylphosphine oxide, methyl phenylglyoxylate, benzyl, and camphorquinone. As the radical polymerization initiator, a single component may be used, or two or more components may be used in combination.

The resin composition preferably further includes a latent curing accelerator. The latent curing accelerator is a compound that is inactive at room temperature but is activated by heating to function as a curing accelerator. Examples of the latent curing accelerator may include: an imidazole compound that is solid at normal temperature; a solid dispersion-type amine adduct-based latent curing accelerator such as a reaction product between an amine compound and an epoxy compound (amine-epoxy adduct-based latent curing accelerator); and a reaction product between an amine compound and an isocyanate compound or urea compound (urea-type adduct-based latent curing accelerator).

Representative examples of a commercially available product of the latent curing accelerator may include, as the amine-epoxy adduct-based (amine adduct-based) latent curing accelerator, "Amicure PN-23" (trade name, Ajinomoto Fine-Techno Co., Inc.), "Amicure PN-40" (trade name, Ajinomoto Fine-Techno Co., Inc.), "Amicure PN-50" (trade name, Ajinomoto Fine-Techno Co., Inc.), "Hardener X-3661S" (trade name, A.C.R. Co., Ltd.), "Hardener X-3670S" (trade name, A.C.R. Co., Ltd.), "Novacure HX-3742" (trade name, Asahi Kasei E-materials Corporation), "Novacure HX-3721" (trade name, Asahi Kasei E-materials Corporation), "Novacure HXA9322HP" (trade name, Asahi Kasei E-materials Corporation), "Novacure HXA3922HP" (trade name, Asahi Kasei Corp.), "Novacure HXA3932HP" (trade name, Asahi Kasei Corp.), "Novacure HXA5945HP" (trade name, Asahi Kasei Corp.), "Novacure HXA9382HP" (trade name, Asahi Kasei Corp.), and "FXR1121" (trade name, T&K TOKA Co., Ltd.). Examples as the urea-type adduct-based latent curing accelerator may include "Fujicure FXE-1000" (trade name, T&K TOKA Co., Ltd.) and "Fujicure FXR-1030" (trade name, T&K TOKA Co., Ltd.). However, the latent curing accelerator is not limited to these. As the component (C), a single component may be used, or two or more components may be used in combination. The latent curing accelerator as the component (C) is preferably a solid dispersion-type amine adduct-based latent curing accelerator, from the viewpoint of pot life and curing properties.

The content of the latent curing accelerator, relative to 100 parts by mass of the resin composition, is preferably 0.1 to 40 parts by mass, from the viewpoint of the curing speed and pot life of the resin composition.

The resin composition may further include, as necessary, carbon black, titan black, silica filler, alumina filler, talc filler, PTFE filler, silane coupling agent, ion trapping agent, leveling agent, antioxidant, defoamer, thixotropic agent, and/or other additives, within the range that does not impair the object of the present embodiment. The resin composition may also include a viscosity modifier, flame retardant, solvent. carbon black and titan black can be used as a material for providing light blocking properties. From the viewpoint of striking a balance between light blocking properties and UV curing properties (curing depth), titan black is preferably used. Examples of titan black may include Titan Black 12S (manufactured by Mitsubishi Materials Electronic Chemicals Co., Ltd.), Titan Black 13M (manufactured by Mitsubishi Materials Electronic Chemicals Co., Ltd.), Titan Black 13M-C (manufactured by Mitsubishi Materials Electronic Chemicals Co., Ltd.), NITRBLACK UB-1 (manufactured by Mitsubishi Materials Electronic Chemicals Co., Ltd.), and Tilack D (manufactured by Ako Kasei Co., Ltd.). Titan black is particularly preferably Titan Black 13M. Also, when the cured product of the resin composition according to the present embodiment has a Tg of 50°C or lower, talc can be used to improve drop impact resistance. Therefore, the resin composition according to the present embodiment preferably includes talc. The content of talc, relative to 100 parts by mass of the resin composition, is preferably 5 to 20 parts by mass, more preferably 5 to 15 parts by mass.

The resin composition can be obtained by, for example, simultaneously or separately stirring, melting, mixing, and/or dispersing the component (A) to the component (C), other additives, while performing a heat treatment as necessary. An apparatus for the mixing, stirring, dispersing, is not particularly limited. Examples of such an apparatus to be used may include a kneader, Henschel mixer, triple roll mill, ball mill, planetary mixer, and bead mill, which are equipped with a stirrer and a heater. These apparatuses may also be used in an appropriate combination.

The resin composition obtained in this manner has light curing properties and heat curing properties. When the resin composition is used in an image sensor module, the heat curing temperature of the resin composition is preferably 70 to 80°C.

The resin composition according to the present embodiment can be used as, for example, an adhesive agent for bonding components with each other or a material thereof.

### [Adhesive agent]

The adhesive agent according to the present embodiment includes the above-described resin composition. This adhesive agent enables favorable bonding with engineering plastics, ceramics, and metal.

### [Cured product of resin composition]

The cured product of the resin composition according to the present embodiment is a cured product of the above-described resin composition.

### [Semiconductor device and electronic component]

The semiconductor device according to the present embodiment includes a cured product of the above-described resin composition. Therefore, this semiconductor device has high moisture resistance reliability. The electronic component according to the present embodiment includes this semiconductor device. Therefore, this electronic component has high moisture resistance reliability.

### EXAMPLES

Hereinafter, the present embodiment will be described by examples. However, the technology of the present embodiment is not limited to these examples. It is noted that in the following examples, parts and % indicate parts by mass and % by mass respectively, unless otherwise stated.

As (A1) M7100 of Component (A), polyester acrylate (product name: M7100, acrylate equivalent weight:152 g/eq) manufactured by Toagosei Co., Ltd. was used.

As (A2) DCP-A of Component (A), dimethylol-tricyclodecane diacrylate (product name: Light Acrylate DCP-A, acrylate equivalent weight: 188 g/eq) manufactured by Kyoeisha Chemical Co., Ltd. was used.

As (B1) PEPT of Component (B), thiol resin (product name: PEPT, thiol equivalent weight: 124 g/eq) manufactured by SC Organic Chemical Co., Ltd. was used.

As (B2) C3 TS-G of Component (B), a glycoluril derivative (product name: C3 TS-G, thiol equivalent weight: 114 g/eq) manufactured by Shikoku Chemicals Corporation was used.

As (B3) PEMT of Component (B), pentaerythritol tetrakis(3-mercaptopropionate) (product name: PEMP, thiol equivalent weight: 128 g/eq) manufactured by SC Organic Chemical Co., Ltd. was used.

As 99.99% calcium carbonate of Component (C), (product name: CS4NA, average particle size: <0.5 µm) manufactured by Ube Material Industries, Ltd. was used.

As 98% calcium carbonate of Component (C'), calcium carbonate (product name: Whiton SB red, average particle size: 1.8 µm) manufactured by Shiraishi Kogyo Kaisha, Ltd. was used.

As silica of Component (C"), silica (product name: SO-E2, average particle size: 0.6 µm) manufactured by Admatechs Company Limited was used.

As magnesium hydroxide of Component (C‴), magnesium hydroxide (product name: UD-653, average particle size: ≤10 µm) manufactured by Ube Material Industries, Ltd. was used.

As aluminum hydroxide of Component (C""), aluminum hydroxide (product name: C-301N, average particle size: 1.5 µm) manufactured by Sumitomo Chemical Company, Limited was used.

As a radical polymerization initiator of others, 2,4,6-trimethylbenzoyl-diphenyl-phosphine oxide (product name: IRGACURE TPO) manufactured by BASF SE was used.

As a latent curing accelerator, an amine-epoxy adduct-based solid dispersion-type latent curing accelerator (product name: FXR1211) manufactured by T&K TOKA Co., Ltd. was used.

As talc, talc (product name: 5000PJ, average particle size: 4 µm) manufactured by Matsumura Sangyo Co., Ltd. was used.

As a silane coupling agent, 3-glycidoxypropyltrimethoxysilane (product name: KBM-403) manufactured by Shin-Etsu Silicone was used.

### [Examples 1 to 9 and Comparative Examples 1 to 4]

Adhesive agents including the resin composition were prepared using a triple roll mill with formulations illustrated in Tables 1 and 2.

### [Shear strength]

A SUS substrate was printed with each of the adhesive agents. The coating size was 2 mm ϕ. On the printed adhesive agent, an alumina chip of 3.2 mm × 1.6 mm × 0.45 mm in thickness was placed. The curing condition was an UV irradiation amount of 2000 mJ/cm² (UV wavelength: 365 nm, LED lamp) and thereafter 80°C/60 minutes in a blast dryer.

A test piece obtained in this manner was subjected to a pressure cooker test (hereinafter, a PCT) (2 atm, 121°C, 100% RH, 20 hours). Thereafter, using a "DAGE 4000" multipurpose bondtester manufactured by dage Co., the alumina chip was loaded. Then, the shear stress (N) when the chip was peeled was measured. Such measurement was performed ten times for one test piece. An average of ten measurement values was calculated as a measurement value of shear strength after a moisture resistance test. The shear strength is preferably 50 N or more. Table 1 and Table 2 illustrate the measurement result (evaluation result) of shear strength.

### [Peel strength]

For Examples 1, 5, 8, and 9, peel strength was measured. A bottom substrate (glass smooth plate: 40 mm × 60 mm × 0.3 mm) was coated with the resin composition to achieve 20 mm × 60 mm and 50 µm in thickness. On the bottom substrate, a top substrate (SUS-304 ribbon (20 µm in thickness, 5 mm in width, 50 mm in length)) was placed while paying attention not to introduce air bubbles. In this manner, five test pieces, each having a 5 mm × 20 mm adhesive surface, were prepared. In curing, the back surface of the test piece was irradiated with UV at an irradiation amount of 2000 mJ/cm ² (UV wavelength: 365 nm, LED lamp). Thereafter, the test piece was cured in a blast dryer at 80°C/60 minutes.

Thereafter, using a peel tester (an LTS-500N-S100 load measuring device manufactured by Minebea Co., Ltd., and a 90° peeling jig), the top substrate of the test piece was grasped, and slightly peeled at one end of the cured product at room temperature. Thereafter, the top substrate was peeled under the conditions of 90°, pulling speed: 50 mm/min, and pulling distance: 15 mm. At this time, the test piece followed the substrate by the same distance in the horizontal direction. The average value of the force required for the peeling when the pulling distance was 5 to 15 mm was calculated as peel strength. Table 3 illustrates the measurement result of peel strength.

### [Glass transition temperature (Tg)]

The resin compositions of Examples 1, 5, 8 and 9 were each sandwiched between two glass plates (smooth plate: 40 mm × 60 mm × 0.3 mm), such that the film thickness after curing became 500 ± 100 µm. Accordingly, a coat was formed. In curing the resin composition, the coat was irradiated with UV at an irradiation amount of 2000 mJ/cm² (UV wavelength: 365 nm, LED lamp). Thereafter, the glass plates containing the coat were left to stand in a blast dryer at 80°C/60 minutes. This coat was peeled from the glass plates. Thereafter, the coat was cut by a cutter into a prescribed dimension (5 mm × 40 mm). It is noted that the cut edges were finished with sandpaper such that they became smooth. This coat was measured at a frequency of 10 Hz by a tensile method in accordance with JIS C6481, using a dynamic thermomechanical analyzer (DMA) manufactured by Seiko Instruments Inc. The value of the tan δ peak was calculated as Tg. Table 3 illustrates the measurement result of Tg.

### [Drop impact resistance]

(i) Each of the resin compositions (samples) of Examples 1, 5, 8 and 9 was applied as an adhesive agent on a SUS substrate. The applied size was set to be width: 9 mm × length: 9 mm × thickness: 0.3 mm.
(ii) On the applied sample, an Ni coat block was placed to form a test piece.
(iii) The test piece was put in an oven heated to 80°C, and the sample was heated and cured for 60 minutes.
(iv) After the sample was heated and cured, the test piece was removed from the oven. Using a drop impact tester (manufactured by Hitachi Technologies and services, Ltd.), the drop impact resistance of the test piece was measured at room temperature. In this measurement, the test piece was dropped from varied heights. The height when the Ni coat block of the test piece was peeled from the SUS plate due to the impact associated with the drop was calculated as a measured value (unit: mm) indicating the drop impact resistance of the test piece. The test piece was dropped from a height of 200 mm first, and then the height was increased by 100 mm until it reached 500 mm. Once the height became 500 mm or more, it was increased by 50 mm. From each height, the test piece was dropped five times. If the Ni coat block was not peeled from the SUS plate, the height was increased to continue the measurement. Table 3 illustrates the measurement result of drop impact resistance.

**[Table 1]**

| | | Example 1 | Example 2 | Example 3 | Example 4 | Example 5 | Example 6 |
|---|---|---|---|---|---|---|---|
| Component (A) | (A1) M7100 | 25.5 | 0.0 | 19.0 | 26.5 | 25.5 | 25.0 |
| | (A2) DCP-A | 25.5 | 50.0 | 19.0 | 26.5 | 25.5 | 25.0 |
| Component (B) | (B1) PEPT | 0.0 | 0.0 | 0.0 | 0.0 | 10.0 | 36.0 |
| | (B2) C3 TS-G | 35.0 | 36.0 | 25.0 | 36.0 | 25.0 | 0.0 |
| | (B3) PEMP | 0.0 | 0.0 | 0.0 | 0.0 | 0.0 | 0.0 |
| Component (C) | 99.99% Calcium carbonate | 10.0 | 10.0 | 33.0 | 7.0 | 10.0 | 10.0 |
| Component (C') | 98% Calcium carbonate | 0.0 | 0.0 | 0.0 | 0.0 | 0.0 | 0.0 |
| Component (C") | Silica | 0.0 | 0.0 | 0.0 | 0.0 | 0.0 | 0.0 |
| Component (C‴) | Magnesium hydroxide | 0.0 | 0.0 | 0.0 | 0.0 | 0.0 | 0.0 |
| Component (C‴) | Aluminum hydroxide | 0.0 | 0.0 | 0.0 | 0.0 | 0.0 | 0.0 |
| Others | Radical polymerization initiator | 1.0 | 1.0 | 1.0 | 1.0 | 1.0 | 1.0 |
| | Latent curing accelerator | 2.0 | 2.0 | 2.0 | 2.0 | 2.0 | 2.0 |
| | Silane coupling agent | 1.0 | 1.0 | 1.0 | 1.0 | 1.0 | 1.0 |
| Total | | 100.0 | 100.0 | 100.0 | 100.0 | 100.0 | 100.0 |
| Evaluation result | PCT, Shear strength after 20 hrs (unit: N) | 120 | 120 | 120 | 80 | 100 | 90 |

**[Table 2]**

| | | Example 7 | Example 8 | Example 9 | Comparative Example 1 | Comparative Example 2 | Comparative Example 3 | Comparative Example 4 |
|---|---|---|---|---|---|---|---|---|
| Component (A) | (A1) M7100 | 19.0 | 23.0 | 22.5 | 25.5 | 25.5 | 25.5 | 25.5 |
| | (A2) DCP-A | 19.0 | 23.0 | 22.5 | 25.5 | 25.5 | 25.5 | 25.5 |
| Component (B) | (B1) PEPT | 0.0 | 0.0 | 9.0 | 0.0 | 0.0 | 0.0 | 0.0 |
| | (B2) C3 TS·G | 0.0 | 30.0 | 22.0 | 35.0 | 35.0 | 35.0 | 35.0 |
| | (B3)PEMP | 28.0 | 0.0 | 0.0 | 0.0 | 0.0 | 0.0 | 0.0 |
| Component (C) | 99.99% Calcium carbonate | 30.0 | 10.0 | 10.0 | 0.0 | 0.0 | 0.0 | 0.0 |
| Component (C') | 98% Calcium carbonate | 0.0 | 0.0 | 0.0 | 10.0 | 0.0 | 0.0 | 0.0 |
| Component (C") | Silica | 0.0 | 0.0 | 0.0 | 0.0 | t 10.0 | 0.0 | 0.0 |
| Component (C") | Magnesium hydroxide | 0.0 | 0.0 | 0.0 | 0.0 | 0.0 | 10.0 | 0.0 |
| Component (C"') | Aluminum hydroxide | 0.0 | 0.0 | 0.0 | 0.0 | 0.0 | 0.0 | 10.0 |
| Others | Radical polymerization inillator | 1.0 | 1.0 | 1.0 | 1.0 | 1.0 | 1.0 | 1.0 |
| | Latent curing accelerator | 2.0 | 2.0 | 2.0 | 2.0 | 2.0 | 2.0 | 2.0 |
| | Talc | 0.0 | 10.0 | 10.0 | 0.0 | 0.0 | 0.0 | 0.0 |
| | Silane coupling agent | 1.0 | 1.0 | 1.0 | 1.0 | 1.0 | 1.0 | 1.0 |
| Total | | 100.0 | 100.0 | 100.0 | 100.6 | 100.0 | 100.0 | 100.0 |
| Evaluation result I | PCT, Shear strength after 20 hrs (unit N) | 60 | 120 | 100 | 40 | 10 | 20 | 10 |

**[Table 3]**

| | Example 1 | Example 5 | Example 8 | Example 9 |
|---|---|---|---|---|
| Peel strength (unit: N/mm) | 1 | 8 | 1 | a |
| Tg (unit: °C) | 75 | 45 | 75 | 45 |
| Drop impact resistance (unit: mm) | 200 | 600 | 200 | 1300 |

As understood from Table 1 and Table 2, in all of Examples 1 to 9, shear strength after a moisture resistance test was high, and moisture resistance reliability was high. On the contrary, shear strength after a moisture resistance test was low, and furthermore, moisture resistance reliability was low, in all of Comparative Example 1 in which the component (C') was used instead of the component (C), Comparative Example 2 in which the component (C") was used instead of the component (C), Comparative Example 3 in which the component (C") was used instead of the component (C), and Comparative Example 4 in which the component (C‴) was used instead of the component (C).

Also, as understood from Table 3, peel strength was higher in Examples 5 and 9 in which a glycoluril compound and a thiol represented by general formula (4) were used in combination as the component (B) than in Example 1 in which a glycoluril compound was used alone. Furthermore, drop impact resistance was excellent in Example 9 which had a Tg of 50°C or lower and contained talc.

### INDUSTRIAL APPLICABILITY

The resin composition according to the present embodiment is a resin composition that has high moisture resistance reliability after curing (particularly, high shear strength after a moisture resistance test), is curable at low temperature, and has light curing properties and heat curing properties. This resin composition is extraordinarily useful particularly as an adhesive agent.

## Claims

1. A resin composition comprising:
(A) a multifunctional (meth)acrylate resin;
(B) a multifunctional thiol resin; and
(C) a calcium carbonate filler having a purity of 99% or more.

2. The resin composition according to claim 1, wherein the component (B) includes a multifunctional thiol resin having no ester bond in the molecule.

3. The resin composition according to claim 1 or 2, wherein the component (B) includes 50 to 100 parts by mass of a glycoluril compound relative to 100 parts by mass of the component (B).

4. The resin composition according to any one of claims 1 to 3, wherein the component (B) includes a multifunctional thiol resin having an ester bond in the molecule.

5. The resin composition according to any one of claims 1 to 4, further comprising talc.

6. An adhesive agent comprising the resin composition according to any one of claims 1 to 5.

7. A cured product of the resin composition according to any one of claims 1 to 5.

8. A semiconductor device comprising the cured product according to claim 7.

9. An electronic component comprising the semiconductor device according to claim 8.

## Patentansprüche

1. Eine Harzzusammensetzung, die folgende Merkmale aufweist:
(A) ein multifunktionales (Meth)acrylatharz;
(B) ein multifunktionales Thiolharz, und
(C) ein Calciumcarbonat-Füllmittel mit einer Reinheit von 99 % oder mehr.

2. Die Harzzusammensetzung gemäß Anspruch 1, wobei die Komponente (B) ein multifunktionales Thiolharz ohne Esterbindung in dem Molekül aufweist.

3. Die Harzzusammensetzung gemäß Anspruch 1 oder 2, wobei die Komponente (B) 50 bis 100 Massenteile einer Glycolurilverbindung relativ zu 100 Massenteilen der Komponente (B) umfasst.

4. Die Harzzusammensetzung gemäß einem der Ansprüche 1 bis 3, wobei die Komponente (B) ein multifunktionales Thiolharz mit einer Esterbindung in dem Molekül aufweist.

5. Die Harzzusammensetzung gemäß einem der Ansprüche 1 bis 4, die ferner Talk aufweist.

6. Ein Haftmittel, das die Harzzusammensetzung gemäß einem der Ansprüche 1 bis 5 aufweist.

7. Ein ausgehärtetes Produkt der Harzzusammensetzung gemäß einem der Ansprüche 1 bis 5.

8. Eine Halbleitervorrichtung, die das ausgehärtete Produkt gemäß Anspruch 7 aufweist.

9. Eine elektronische Komponente, die die Halbleitervorrichtung gemäß Anspruch 8 aufweist.

## Revendications

1. Composition de résine comprenant:
(A) une résine de (méth)acrylate multifonctionnelle;
(B) une résine de thiol multifonctionnelle; et
(C) une charge de carbonate de calcium ayant une pureté de 99 % ou plus.

2. Composition de résine selon la revendication 1, dans laquelle le composant (B) comporte une résine de thiol multifonctionnelle ne présentant pas de liaison ester dans la molécule.

3. Composition de résine selon la revendication 1 ou 2, dans laquelle le composant (B) comporte de 50 à 100 parties en masse d'un composé de glycolurile pour 100 parties en masse du composant (B).

4. Composition de résine selon l'une quelconque des revendications 1 à 3, dans laquelle le composant (B) comporte une résine de thiol multifonctionnelle présentant une liaison ester dans la molécule.

5. Composition de résine selon l'une quelconque des revendications 1 à 4, comprenant par ailleurs du talc.

6. Agent adhésif comprenant la composition de résine selon l'une quelconque des revendications 1 à 5.

7. Produit durci de la composition de résine selon l'une quelconque des revendications 1 à 5.

8. Dispositif semi-conducteur comprenant le produit durci selon la revendication 7.

9. Composant électronique comprenant le dispositif semi-conducteur selon la revendication 8.
